# EUROPEAN PATENT SPECIFICATION

(11) **EP 0 926 258 B1**
(45) Date of publication and mention of the grant of the patent: **19.03.2003**
(21) Application number: 98830740.1
(22) Date of filing: 09.12.1998
(51) Int. Cl.: C23C 14/56, H01J 7/18, H01J 37/18

(54) **Getter system for purifying the working atmosphere in physical vapor deposition processes**
Getter-System zur Behandlungsatmosphäre-Reinigung in physikalischen Dampfphasenabscheidungs-Verfahren
Système de getter pour purifier l'atmosphère de travail de procédés de déposition physique en phase vapeur

(30) Priority: 23.12.1997 IT MI972862
(43) Date of publication of application: 30.06.1999
(73) Proprietor: SAES GETTERS S.p.A., 20020 Lainate (Milano) (IT)
(72) Inventor: Conte, Andrea, Milano (IT); Mazza, Francesco, Milano (IT)
(74) Representative: Adorno, Silvano

(56) References cited:
- EP-A- 0 693 626
- EP-A- 0 719 609
- WO-A-97/17542
- HEYDER R ET AL: "NONEVAPORABLE GETTERING TECHNOLOGY FOR IN-SITY VACUUM PROCESSES" SOLID STATE TECHNOLOGY,US,COWAN PUBL.CORP. WASHINGTON, vol. 39, no. 8, 1 August 1996 (1996-08-01), pages 71-72,74, XP000620116 ISSN: 0038-111X

## Description

The present invention relates to PVD apparatus including a getter system for purifying the work atmosphere in the processes of physical vapor deposition.

The deposition processes of thin layers of metallic or ceramic materials from suitable vapors or plasmas are more and more widely used in the industry, and are generally referred to in the field by the English term "Physical Vapor Deposition", or by its acronym PVD. These processes are used e.g. in the semiconductor field for depositing a number of layers, that are then selectively removed for obtaining the integrated circuits, or in the compact disc industry for forming the reflecting layer of aluminum.

In all these processes a high purity is required for the used gases. In particular, in the semiconductor production, impurities in process gases result in microflaws in the electronic devices, and the smaller the size of the devices, the greater the effect of such flaws on the working of such devices. Owing to the constant trend of reduction of the average size of these devices, it is necessary to use a process gas more and more pure in order to reduce the scrap percentage.

The use of getter materials combined with conventional pumps for purifying gases upstream with respect to the PVD processes is by now a common practice in the industry. However, the purity control of inlet gases in the production lines is not sufficient, since the impurities may enter in the work atmosphere resulting from the degassing of the materials forming the walls or other parts of the chamber. In particular, some processes such as the deposition of aluminium or titanium nitride layers may result in contamination. These depositions are made by the technique known by the English term "sputtering", wherein a flat surface of a "target", consisting of the material to be deposited, is eroded due to the impact of ions of heavy atoms (generally Ar⁺ ions) accelerated by a suitable electric field; the particles removed from the target surface are deposited in form of thin layers onto the substrate of semiconductor material, being generally arranged parallel with respect to the target surface. The gases in the target, e.g. mechanically included in the structure of the material during its production, are discharged during the sputtering process, thus resulting in a high concentration of impurities in the work area. The most common among the impurities are H₂O, H₂, CO, CO₂ and CH₄, and their concentration may range, depending upon the specific features of each process, from about 1 to 100 ppm.

Laid-open patent applications WO 96/13620, WO 96/17171, EP 693626 and WO 97/17542 refer to the gas purifying with getter pumps arranged inside the PVD chambers. These applications disclose getter pumps being arranged inside the chambers in portions far from the work areas. The main advantage obtained by using these pumps *in situ* is the reduction of the dead times being necessary to bring the level of impurities below a predetermined value, after every opening of the chamber, e.g. for maintenance operations.

However, these systems do not solve, or solve only partially, the problem due to the impurities in the work area during the PVD operations, since this area is defined by screens acting so as to prevent the target material from being deposited onto undesired portions of the chamber, such as e.g. feedthroughs, openings for connecting the chamber to gas lines, etc.. These screens have the side-effect of greatly reducing the gas conductance between the work area and the remaining volume of the chamber, thus producing two different gaseous atmospheres inside the process chamber, so that the sorption of the impurities in the work area by the aforementioned *in situ* getter pumps is negligible. Thus, the problem of an effective purifying of the work atmosphere during the PVD process and of the resulting contamination of the layers deposited onto a support by these processes is not yet solved.

The object of the present invention is to provide a getter system for purifying the gaseous atmosphere in the work area in the processes of physical vapor deposition.

This object is achieved according to the present invention by PVD apparatus including a getter system formed of one or more essentially planar getter devices being inserted inside the work area of a process chamber for physical vapor deposition, in such an arrangement that said getter devices are essentially parallel and spaced apart with respect to the screens defining said work area and the space between the getter devices and the screens is connected to the work area, said getter devices being such that at least the surface facing the screens is made of getter material.

The invention will be hereinafter described with reference to the drawings, wherein:
- Figure 1 shows in diagrammatic form a process chamber for physical vapor deposition;
- Figure 2 shows in outline the positioning of the getter system inside the process chamber of Figure 1;
- Figures 3 and 4 show some embodiments of a first type of getter devices which may be used in the system of the invention;
- Figure 5 shows a possible getter system of the invention formed of devices of Figure 3;
- Figure 6 shows a possible alternative embodiment of a second type of getter devices which may be used in the system of the invention;
- Figure 7 shows another possible getter system of the invention formed of devices of Figure 6.

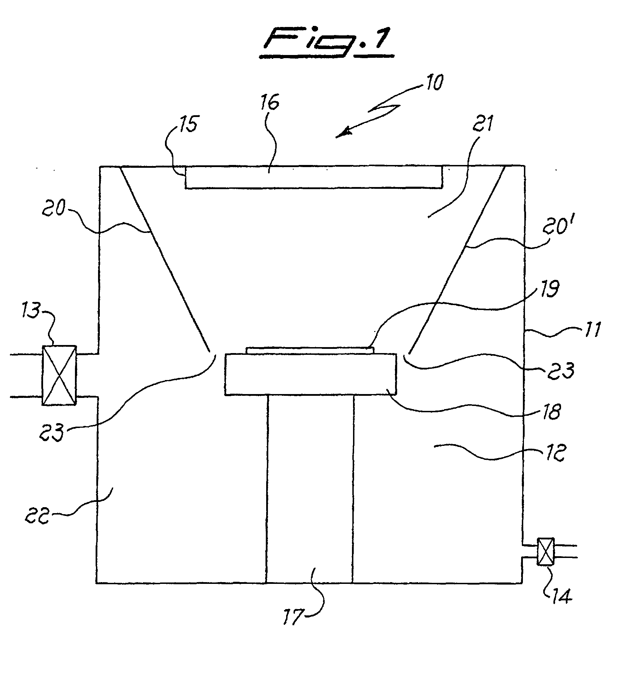

Referring to Figure 1, a process chamber is diagrammatically shown for the production of integrated devices. A chamber 10 is formed of a housing 11 defining a space 12 isolated from the atmosphere. The chamber has connected thereto a pumping system for its evacuation, which is generally indicated in Figure as 13, and at least a feeding line for the process gas, which is generally indicated as 14. Inside chamber 10 there are a target 15, being generally shaped as a disk or a short cylinder and made of material 16 to be deposited as a thin layer; a support 17 carrying a housing 18 for a substrate 19 made of a semiconductor material (generally silicon), to have the thin layer of material 16 deposited thereon; finally, there are screens 20, 20', ... (only two are shown in the Figure). Screens 20, 20', ... divide space 12 in two areas, a work area 21 and an area 22 having therein the auxiliary structures of PVD process, such as the electric connections or the inlets of the gas feeding lines; areas 21 and 22 contact one another only through a small conductance 23 at the edge of the screens. There is a wide variety of modifications to the simple scheme outlined above. For example, work area 21 may be square-, rectangular- or cylindrical-shaped; anyway, generally the screens are essentially planar and inserted inside chamber 10 with the polygonal arrangement being the most suitable to define the desired geometry in the work area. Target 15 may be made of a forerunner of material 16 to be deposited onto substrate 19, or may be part of a system of multiple targets, which is used in some cases for allowing the sequential deposition of layers of different materials without having to open the chamber. Support 17 may be generally shifted in a vertical direction for bringing substrate 19 to the working position, while housing 18 is generally heated in order to keep substrate 19 at a temperature being optimal for obtaining a thin layer with good homogeneity properties; this temperature, depending upon material 16, generally ranges from about 100 to 500 °C.

The getter pumps of the known technique are arranged in various positions inside chamber 10, anyhow always in area 22, and thus they are practically isolated from the gaseous atmosphere of area 21 due to the small conductance between areas 21 and 22.

On the contrary, according to the present invention, the getter system is arranged inside area 21 and thus is in an effective position for sorbing the impurities in this area.

In particular, the getter system according to the invention is formed of essentially planar getter devices which are fastened to the screens so that they are essentially parallel with respect to the screens, there is a space between screens and getter devices and such a space is connected to work area 21; furthermore, the getter devices must be fastened to the screens so as to have at least the surface facing the screens made of getter material.

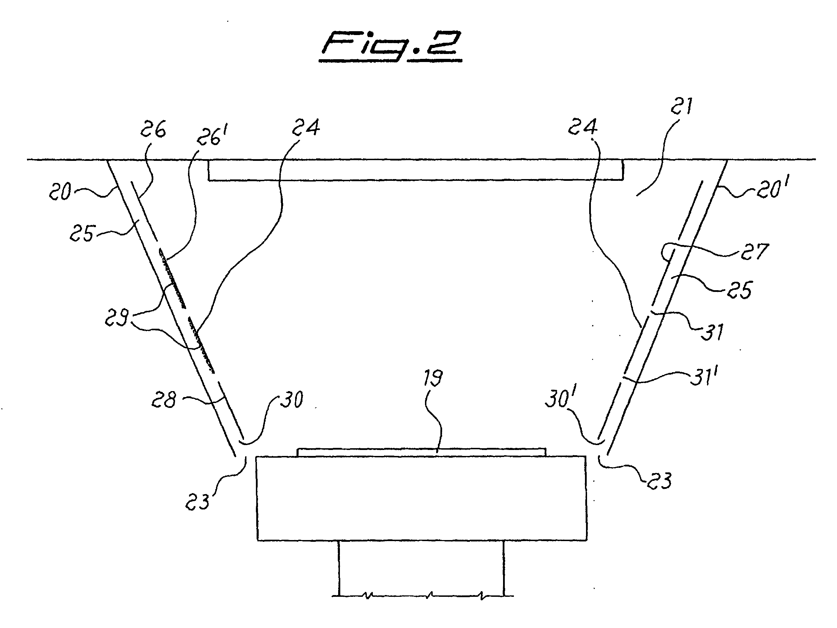

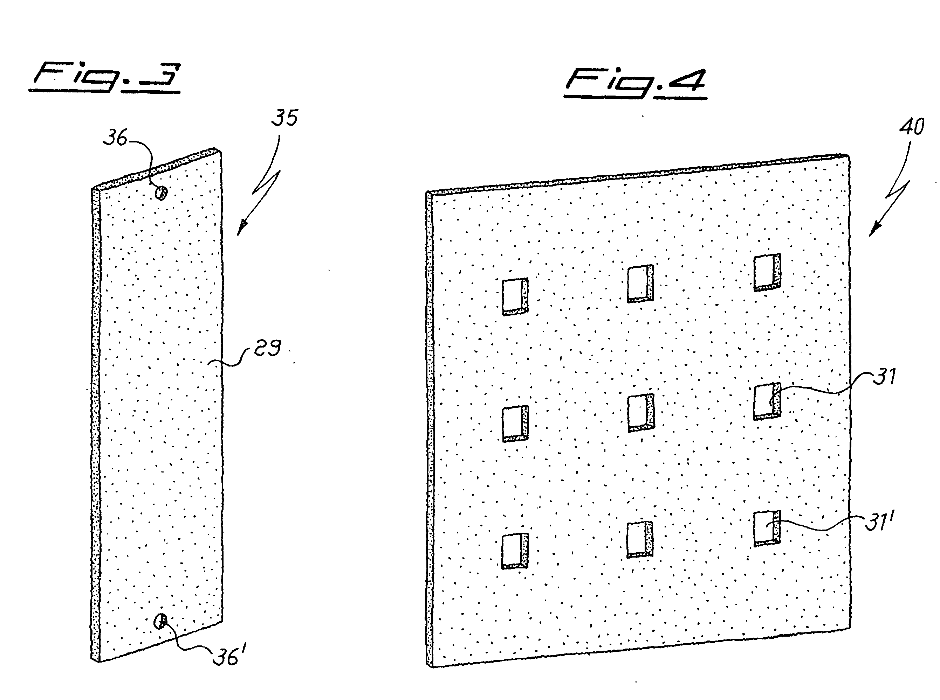

Figure 2 shows in outline the arrangement of the getter system of the invention inside a PVD process chamber. A getter system 24 is essentially parallel with respect to screens 20, 20', and it defines a space 25 between said screens and system 24. System 24 is formed of getter devices 26, 26', ... ; the Figure does not show the means for fastening devices 26, 26' to screens 20, 20', ..., since such means are different depending upon the specific type of used getter devices, as hereinafter described. Getter system 24 has a surface 27 facing work area 21 and a surface 28 facing screens 20, 20', ... ; at least surface 28 must be made of a getter material 29. System 24 may be arranged around the work area so as to sweep an angle smaller than 360°, but preferably it wholly encloses the work area, thus increasing the available surface of getter material and the efficiency of the impurity sorption. As previously said, whatever the geometry of the work area may be, generally the screens are essentially planar, as well as getter devices 26, 26', ... forming the system according to the invention. Should the getter system sweep an angle smaller than 360° around work area 21, it may consist only of a single getter device. However, as previously said, the getter system preferably sweeps a 360° angle around the work area, being in this case formed of several getter devices, and generally of at least as many getter devices as the screens.

Space 25 must be connected to area 21. The condition of the connection between space 25 and area 21 may be complied with in many ways, e.g. by such getter devices that surface 27 is continuous and there is conductance between area 21 and space 25 at areas 30, 30' indicated in Figure 2. However, the required condition is preferably complied with by getter devices 26, 26', ... shaped or arranged so that surface 27 is discontinuous; in particular, it has been found that the best efficiency in removing impurities from area 21 is obtained when the surface 27 being effective, i.e. the sum of the surfaces facing area 21 for all the getter devices, is a fraction of the available surface for a continuous getter system 24 ranging from 70 to 99%, and preferably from 80 to 95%. The discontinuities of surface 27 may be in form of through-holes in devices 26, 26' or of void spaces between adjacent devices; both these possibilities are shown in the Figure, the discontinuities being indicated as 31, 31', ..... In both cases, the discontinuities may have a regular or an irregular shape, and be regularly or irregularly arranged on the available surface; for example, in case of holes on the surface of a single getter device, they may be square- or round-shaped, or irregularly shaped, and be arranged on the surface of the getter device network-like or random; in case of spacings between adjacent getter devices, the shape and the arrangement of the discontinuities depend upon whether devices 26, 26', ... are regularly arranged on the available surface or not. Generally, regular shapes and arrangements of the discontinuities are preferred, both on single getter devices and between adjacent devices, in that more suitable for an automated production of getter system 24 and allowing an easier control of the aforementioned condition for the ratio between effective surface and available surface for system 24. Mixed configurations are obviously possible, wherein single getter devices have holes and adjacent getter devices are spaced apart from one another.

The distance between getter system 24 and screens 20, 20', ... mainly depends upon the overall size of area 21 and the distances between adjacent getter devices and/or the size of the holes on said devices. Generally, the distance between getter system and screens ranges from 1 mm to 5 cm; within these limits, said distance is generally smaller in small-sized PVD-chambers, in order to prevent the getter system from affect the processes occurring in the work area; moreover, said distance increases upon increasing of the distances between adjacent getter devices and/or of the size of the holes on said devices.

A wide variety of getter materials may be used for producing devices 26, 26', ... , including metals such as Zr, Ti, Nb, Ta, V, alloys between these metals or alloys of these metals and one or more elements selected among Cr, Mn, Fe, Co. Ni, Al, Y, La and rare earths, such as binary alloys Ti-V, Zr-V, Zr-Fe and Zr-Ni or ternary alloys Zr-Mn-Fe or Zr-V-Fe, or mixture of the aforementioned metals and alloys. The getter materials most commonly used are the alloy having weight composition Zr 84% - Al 16%, manufactured and sold by the Company SAES GETTERS (Milan, ITALY) under the tradename St 101®; the alloy having weight composition Zr 70% - V 24.6% - Fe 5.4%, manufactured and sold by the Company SAES GETTERS under the tradename St 707™, or mechanical mixtures of these two alloys and Zr or Ti; these mixtures are preferred due to their good mechanical properties, in particular with respect to the particle loss.

Getter devices 26, 26', ... may be bodies made only of getter material, obtained by powder sintering, or may consist of getter material deposited, according to a variety of techniques, onto a metal support.

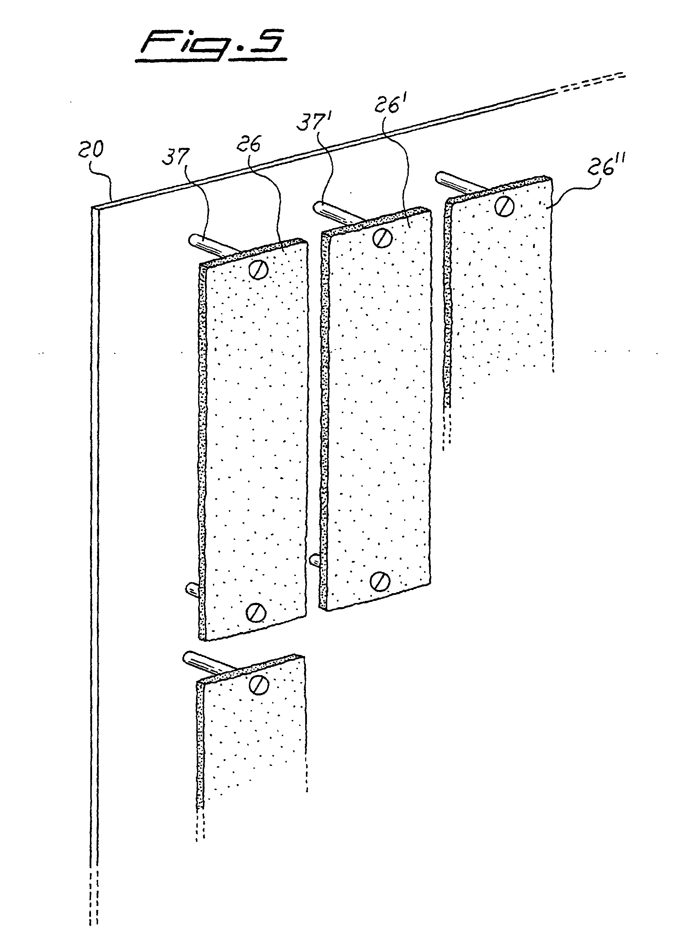

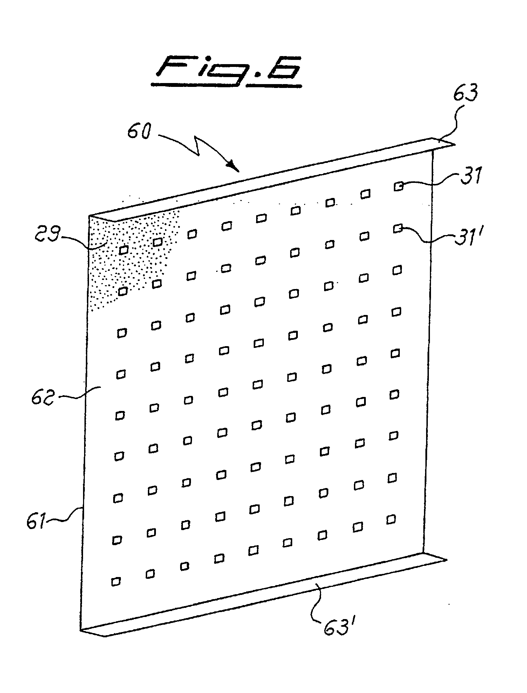

The production of sintered bodies from powders is known in the field of powder metallurgy, and it generally comprises the steps of compressing the powders in a suitable mold and heating the clotted powders until a partial melting of the surface of the powder grains is obtained. Modifications to the method in order to obtain bodies having specific features, e.g. being highly porous, are disclosed e.g. in US patent 5324172 and in patent application EP-A-719609, both in the name of the applicant, and in patent application EP-A-765012. Figures 3 and 4 show getter devices of this type. Device 35 of Figure 3 is rectangular-shaped, and has at its ends through-holes 36, 36', provided for the use of members such as screws and bolts for fastening the device to the screens at the desired distance; it is obviously possible to use other means for fastening the device to the screens, such as e.g. a metal member having integrated therein a frame for retaining the getter body and suitable spacers which may be fastened to the screens; device 40 of Figure 4 is essentially square-shaped and has a series of through-holes 31, 31', ... allowing an easy connection between work area 21 and space 25, as previously mentioned. During the PVD process, the surface facing area 21 is covered by material 16 to be deposited as a thin layer on substrate 19, whereas surface 28 is active for sorbing impurities.

Since planar sintered bodies having side dimensions far greater than their thickness are complex to manufacture and have a low mechanical strength. when using these bodies for the getter system of the invention, this latter is preferably formed of a relatively great number of getter devices, each having a surface considerably smaller than the screen having them fastened thereto. An arrangement of this kind is represented in Figure 5, which shows a portion of a screen 20 having fastened thereto a plurality of devices 26, 26', 26", ... of type 35; devices 26, ..., are fastened to the screen through suitable mounting members 37, 37', also acting as spacers.

Getter devices 26, 26', ... may be also made of getter material deposited onto a metal support. Devices of this type may be produced according to a variety of techniques. A first way is the cold lamination of the getter material powders onto the metal support, according to a technique well known in the field of powders metallurgy. Another way is to spray a suspension of getter particles in a suitable solvent onto the metal support kept hot, such as disclosed in patent application WO 95/23425, to be referred to as for the details of this technique. Furthermore, the metal support may be covered by getter material particles by the electrophoretic technique; as for the details of this technique, patent US 5242559 must be referred to. Finally, the deposition of powders of getter material onto the metal support may be obtained by screen printing technique, such as disclosed in PCT published patent application WO 98/03987. The support may be made of any metal capable of withstanding temperatures of about 600 °C, which may be necessary for the activation of the getter material, and preferably not being ferromagnetic, in order to avoid interferences with the magnetic fields sometimes used in the PVD processes. The use of steel or nickel-chromium alloys is preferred. The thickness of the support may vary within a wide range, and it generally ranges from 0.1 to 1 mm; out of mechanical stability, the thickness of the support preferably increases upon increasing of the side dimensions of getter device 26. The thickness of the getter material deposit 29 in device 26 may vary within a wide range, but, out of production expediency and mechanical stability of the deposit, this thickness generally ranges from about 20 to 500 µm. In this case the getter devices are mounted onto the screens so that the surface of getter material faces these latter. Unlike the aforementioned case, wherein the getter system is formed of sintered bodies, when the getter devices are obtained by depositing the getter material onto a metal support, the system is preferably formed of a relatively small number of such devices, each having a surface similar to that of the screen having them fastened thereto, so that one, or two at the most, of such devices are fastened to each screen. The production of devices of this type, having a relatively large surface, is easy and allows to spare times and costs both in manufacturing the getter devices and in fastening them to the screens.

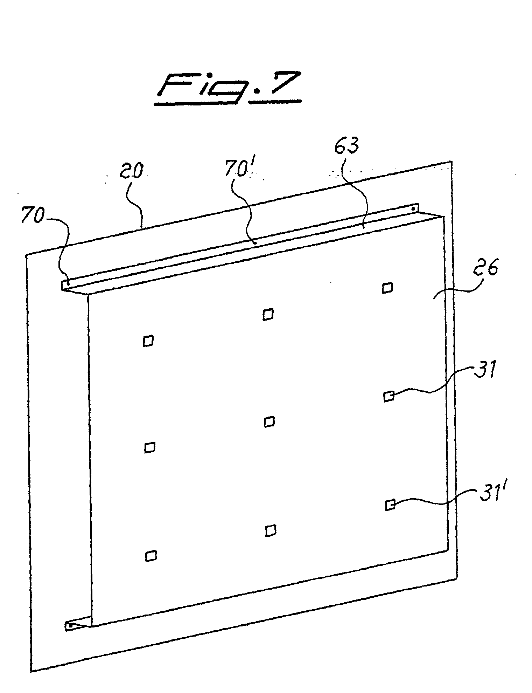

Figure 6 shows a possible embodiment of getter devices obtained by depositing getter material onto a metal support. Device 60 is formed of an essentially planar metal support 61 having deposited on a surface 62 thereof getter material 29 (the Figure shows only a partial covering made of getter material); the device has a plurality of holes 31, 31', ... ; support 61 has preferably distortions, such as e.g. lifted edges 63, 63' shown in the Figure or similar members, acting as spacers between the device and the screen having the device fastened thereto. As previously mentioned, holes 31, 31', ... may be regular-shaped or not, and may be arranged on support 61 as a regular network or not, the first way being preferred for an easier automated production. A possible way of assembling a screen of a PVD chamber and a getter device being part of a system according to the invention is represented in Figure 7, showing a screen 20 having fastened thereto a single device 26 of type 60; device 26 may be fastened to the screen through suitable mechanical mounting members, such as screws, or through welding spots 70, 70', ..., on edge 63 of the getter device.

The getter devices require for their working an activation, generally consisting in the heating, by a variety of means, at temperatures of at least 300 °C. This operation may be made during the preparatory steps of the chamber working, such as e.g. the heating of the whole chamber for degassing the walls and obtaining a better resulting vacuum. Otherwise, the getter device activation may be obtained during the operations of material deposition onto disposable substrates, carried out for cleaning the surface of target 15, which are generally polluted before every deposition step; these operations generally result in a heating of the chamber sufficient to the getter activation.

By the getter system of the invention, another advantage is obtained in case the material to be deposited (16) is titanium. Titanium, deposited as thin layers, is well known as a getter material. During the titanium deposition in the chambers for physical vapor deposition, some metal is deposited also onto the walls of the work area, including the screens. In particular, this thin layer sorbs the hydrogen in the work atmosphere, and, due to this sorption, first swells and then comes off from the surfaces upon which it is in form of metal microlayers; these could reach the substrate being processed, thus affecting its quality and contributing to the scrap percentage. On the contrary, by the system of the invention the hydrogen is preferably sorbed by the getter material, thus overcoming the drawback occurring in the common chambers for physical vapor deposition.

## Claims

1. An apparatus for physical vapour deposition containing a getter system and screens (20, 20',.....) which define a work area (21), **characterized in that** said getter system, formed of one or more essentially planar getter devices (26, 26',....; 35; 40; 60), is inserted inside said work area in such an arrangement that said getter devices are essentially parallel and spaced apart with respect to the screens, and that the space (25) between the getter devices and the screens is connected to the work area, said getter devices being such that at least the surface (28) facing the screens is made of getter material (29).

2. An apparatus according to claim 1, wherein the occupation fraction of the surface (27) of the getter devices facing the work area ranges from 70 to 99% of the available surface.

3. An apparatus according to claim 2, wherein said occupation fraction is obtained by arranging in the work area the getter devices so as not to contact one another.

4. An apparatus according to claim 2, wherein said occupation fraction is obtained by using getter devices having a discontinuous surface.

5. An apparatus according to claim 2, wherein said occupation fraction is obtained by arranging in the work areAn apparatus devices having a discontinuous surface so as not to contact one another.

6. An apparatus according to claim 2, wherein said occupation fraction ranges from 80 to 95%.

7. An apparatus according to claim 1, wherein the distance between the getter devices and the screens ranges from 1 mm to 5 cm.

8. An apparatus according to claim 1, wherein the getter material is selected among the metals Zr, Ti, Nb, Ta, V, the alloys between said metals, the alloys of said metals and one or more metals selected among Cr, Mn, Fe, Co, Ni, Al, Y, La and rare earths, the mixtures of said metals and said alloys.

9. An apparatus according to claim 8, wherein the getter material is the alloy having weight composition Zr 84% - A1 16%.

10. An apparatus according to claim 8, wherein the getter material is the alloy having weight composition Zr 70% - V 24.6% - Fe 5.4%.

11. An apparatus according to claim 8, wherein the getter material is a mixture of the alloy having weight composition Zr 84% - Al 16% and a metal selected among Zr and Ti.

12. An apparatus according to claim 8, wherein the getter material is a mixture of the alloy having weight composition Zr 70% - V 24.6% - Fe 5.4% and a metal selected among Zr and Ti.

13. An apparatus according to claim 1, wherein the getter devices are made only of getter material (35; 40).

14. An apparatus according to claim 13, wherein said getter bodies are obtained by powder sintering.

15. An apparatus according to claim 1, wherein the getter devices are formed of An apparatus material deposit onto a support (61) made of a metal capable of withstanding thermal treatments up to 600 °C.

16. An apparatus according to claim 15, wherein the metal making up the support is not ferromagnetic.

17. An apparatus according to claim 15, wherein the support is made of steel.

18. An apparatus according to claim 15, wherein the support is made of a nickel-chromium alloy.

19. An apparatus according to claim 15, wherein the getter material is deposited onto the metal support by cold lamination.

20. An apparatus according to claim 15, wherein the getter material is deposited onto the metal support by spray technique.

21. An apparatus according to claim 15, wherein the getter material is deposited onto the metal support by electrophoretic technique.

22. An apparatus according to claim 15, wherein the getter material is deposited onto the metal support by screen printing technique.

23. An apparatus according to claim 15, wherein the support has a thickness ranging from 0.1 to 1 mm.

24. An apparatus according to claim 15, wherein the deposit of getter material has a thickness ranging from 20 to 500 µm.

## Patentansprüche

1. Vorrichtung zur PVD-Beschichtung, die ein Gettersystem und Schirme (20, 20',.....) umfasst, die einen Arbeitsbereich (21) definieren, **dadurch gekennzeichnet, dass** das Gettersystem, das aus einer oder mehr im Wesentlichen planaren Gettervorrichtungen (26, 26',.....; 35; 40; 60) gebildet ist, innerhalb des Arbeitsbereiches in so einer Anordnung eingefügt ist, dass die Gettervorrichtungen im Wesentlichen parallel und im Abstand bezüglich der Schirme sind, und dass der Raum (25) zwischen den Gettervorrichtungen und den Schirmen mit dem Arbeitsbereich verbunden ist, wobei die Gettervorrichtungen derartig sind, dass mindestens die Oberfläche (28), die den Schirmen gegenübersteht, aus dem Gettermaterial (29) hergestellt ist.

2. Vorrichtung nach Anspruch 1, wobei sich der Besetzungsanteil der Oberfläche (27) der Gettervorrichtungen, die dem Arbeitsbereich gegenüberstehen, zwischen 70% und 99% der vorhandenen Oberfläche liegt.

3. Vorrichtung nach Anspruch 2, wobei der Besetzungsanteil erreicht ist durch eine derartige Anordnung der Gettervorrichtungen in dem Arbeitsbereich, bei der sie einander nicht berühren.

4. Vorrichtung nach Anspruch 2, wobei der Besetzungsanteil erreicht ist unter Verwendung von Gettervorrichtungen, welche eine unterbrochene Oberfläche aufweisen.

5. Vorrichtung nach Anspruch 2, wobei der Besetzungsanteil erreicht ist durch Anordnung eines Vorrichtungsbauteils in dem Arbeitsbereich, das eine unterbrochene Oberfläche aufweist, so dass sie einander nicht berühren.

6. Vorrichtung nach Anspruch 2, wobei der Besetzungsanteil zwischen 80% und 95% liegt.

7. Vorrichtung nach Anspruch 1, wobei der Abstand zwischen den Gettervorrichtungen und den Schirmen zwischen 1 mm und 5 cm liegt.

8. Vorrichtung nach Anspruch 1, wobei das Gettermaterial ausgewählt ist aus den Metallen Zr, Ti, Nb, Ta, V, den Legierungen zwischen diesen Metallen, den Legierungen dieser Metalle und eines oder mehr Metallen, die aus Cr, Mn, Fe, Co, Ni, Al, Y, La und Seltenerdmetallen, den Mischungen der Metalle und der Legierungen ausgewählt sind.

9. Vorrichtung nach Anspruch 8, wobei das Gettermaterial die Legierung ist, die die Gewichtszusammensetzung Zr 84% - Al 16% aufweist.

10. Vorrichtung nach Anspruch 8, wobei das Gettermaterial die Legierung ist, die die Gewichtszusammensetzung Zr 70% - V 24,6% - Fe 5,4% aufweist.

11. Vorrichtung nach Anspruch 8, wobei das Gettermaterial ein Gemisch der Legierung, die die Gewichtszusammensetzung Zr 84% - Al 16% aufweist, und eines Metalls ist, das aus Zr und Ti ausgewählt ist.

12. Vorrichtung nach Anspruch 8, wobei das Gettermaterial ein Gemisch der Legierung, die die Gewichtszusammensetzung Zr 70% - V 24,6% - Fe 5,4% aufweist, und eines Metalls ist, das aus Zr und Ti ausgewählt ist.

13. Vorrichtung nach Anspruch 1, wobei die Gettervorrichtungen nur aus Gettermaterial (35; 40) hergestellt sind.

14. Vorrichtung nach Anspruch 13, wobei die Getterkörper durch Pulversinterung erhalten sind.

15. Vorrichtung nach Anspruch 1, wobei die Gettervorrichtungen aus einem Apparatematerial gebildet sind, das auf einem Träger (61) aufgebracht ist, der aus einem Metall hergestellt ist, das fähig ist, Wärmebehandlungen bis zu 600°C standzuhalten.

16. Vorrichtung nach Anspruch 15, wobei das Metall, das den Träger bildet, nicht ferromagnetisch ist.

17. Vorrichtung nach Anspruch 15, wobei der Träger aus Stahl hergestellt ist.

18. Vorrichtung nach Anspruch 15, wobei der Träger aus einer Nickel-Chrom-Legierung hergestellt ist.

19. Vorrichtung nach Anspruch 15, wobei das Gettermaterial auf dem Metallträger durch Kaltlaminierung aufgebracht ist.

20. Vorrichtung nach Anspruch 15, wobei das Gettermaterial auf dem Metallträger durch Sprühverfahren aufgebracht ist.

21. Vorrichtung nach Anspruch 15, wobei das Gettermaterial auf dem Metallträger durch elektrophoretisches Verfahren aufgebracht ist.

22. Vorrichtung nach Anspruch 15, wobei das Gettermaterial auf dem Metallträger durch Siebdruckverfahren aufgebracht ist.

23. Vorrichtung nach Anspruch 15, wobei der Träger eine Dicke aufweist, die sich zwischen 0,1 und 1 mm liegt.

24. Vorrichtung nach Anspruch 15, wobei die Schicht des Gettermaterials eine Dicke aufweist, die sich zwischen 20 und 500 µm liegt.

## Revendications

1. Appareil pour un dépôt physique en phase vapeur contenant un système de getter et des écrans (20, 20'...) qui définissent une zone de travail (21), **caractérisé en ce que** ledit système de getter, formé par un ou plusieurs dispositifs de getter sensiblement plans (26, 26', ... 35, 40, 60) est inséré à l'intérieur de ladite zone de travail selon un agencement tel que lesdits dispositifs de getter soient sensiblement parallèles et espacés par rapport aux écrans, et **en ce que** l'espace (25) entre les dispositifs de getter et les écrans est relié à la zone de travail, lesdits dispositifs de getter étant tels qu'au moins la surface (28) orientée vers les écrans soit réalisée en un matériau de getter (29).

2. Appareil selon la revendication 1, où la fraction d'occupation de la surface (27) des dispositifs de getter orientés vers la zone de travail se situe dans une plage de 70 à 99% de la surface disponible.

3. Appareil selon la revendication 2, où ladite fraction d'occupation est obtenue en agençant dans la zone de travail les dispositifs de getter de façon qu'ils ne viennent pas en contact entre eux.

4. Appareil selon la revendication 2, où ladite fraction d'occupation est obtenue en utilisant des dispositifs de getter ayant une surface discontinue.

5. Appareil selon la revendication 2, où ladite fraction d'occupation est obtenue en agençant dans la zone de travail des dispositifs d'appareil An présentant une surface discontinue de manière à ne pas venir en contact les uns avec les autres.

6. Appareil selon la revendication 2, où ladite fraction d'occupation s'étend de 80 à 95%.

7. Appareil selon la revendication 1, où la distance entre les dispositifs de getter et les écrans se situe dans une plage de 1 mm à 5 cm.

8. Appareil selon la revendication 1, où le matériau de getter est sélectionné parmi les métaux Zr, Ti, Nb, Ta, V, les alliages entre lesdits métaux, les alliages desdits métaux et un ou plusieurs métaux sélectionnés parmi Cr, Mn, Fe, Co, Ni, Al, Y, La et des terres rares, les mélanges desdits métaux et desdits alliages.

9. Appareil selon la revendication 8, où le matériau de getter est l'alliage d'une composition en poids de Zr 84%-Al 16%.

10. Appareil selon la revendication 8, où le matériau de getter est l'alliage ayant la composition de poids Zr 70%-V 24,6% - Fe 5,4%.

11. Appareil selon la revendication 8, où le matériau de getter est un mélange de l'alliage ayant la composition de poids Zr 84%-A1 16% et d'un métal sélectionné parmi le Zr et le Ti.

12. Appareil selon la revendication 8, où le matériau de getter est un mélange de l'alliage ayant la composition de poids Zr 70%-V 24,6%- Fe 5,4% et un métal sélectionné parmi le Zr et le Ti.

13. Appareil selon la revendication 1, où les dispositifs de getter sont réalisés seulement en matériau de getter (35 ; 40).

14. Appareil selon la revendication 13, où lesdits corps de getter sont obtenus par frittage de poudre.

15. Appareil selon la revendication 1, où les dispositifs de getter sont formés par un dépôt de matériau d'appareil An sur un support (61) réalisé en métal apte à résister à des traitements thermiques jusqu'à 600°C.

16. Appareil selon la revendication 15, où le métal constituant le support n'est pas ferromagnétique.

17. Appareil selon la revendication 15, où le support est réalisé en acier.

18. Appareil selon la revendication 15, où le support est réalisé en un alliage de nickel-chrome.

19. Appareil selon la revendication 15, où le matériau de getter est déposé sur le support métallique par lamination à froid.

20. Appareil selon la revendication 15, où le matériau de getter est déposé sur le support métallique par une technique de pulvérisation.

21. Appareil selon la revendication 15, où le matériau de getter est déposé sur le support métallique par une technique électrophorétique.

22. Appareil selon la revendication 15, où le matériau de getter est déposé sur le support métallique par une technique de sérigraphie.

23. Appareil selon la revendication 15, où le support a une épaisseur allant de 0,01 à 1 mm.

24. Appareil selon la revendication 15, où le dépôt du matériau de getter a une épaisseur dans la plage de 20 à 500 µm.
